# EUROPÄISCHE PATENTSCHRIFT

(11) **EP 1 133 642 B1**
(45) Veröffentlichungstag und Bekanntmachung des Hinweises auf die Patenterteilung: **15.09.2004**
(21) Anmeldenummer: 99956004.8
(22) Anmeldetag: 17.11.1999
(51) Int. Cl.: F15C 5/00, B01L 11/00

(54) **ANSCHLUSSTRÄGER FÜR PLATTENFÖRMIGE MIKROKOMPONENTEN**
INTERCONNECTION SUPPORT FOR PLATE-LIKE MICROCOMPONENTS
SUPPORT DE CONNEXION POUR MICROCOMPOSANTS SOUS FORME DE PLAQUES

(30) Priorität: 24.11.1998 DE 19854096
(43) Veröffentlichungstag der Anmeldung: 19.09.2001
(60) Teilanmeldung: 04000604.1
(73) Patentinhaber: MERCK PATENT GmbH, 64293 Darmstadt (DE)
(72) Erfinder: HOHMANN, Michael, D-64289 Darmstadt (DE); SCHMELZ, Michael, D-64560 Riedstadt (DE); WURZIGER, Hanns, D-64291 Darmstadt (DE); SCHWESINGER, Norbert, D-85386 Eching (DE)
(74) Vertreter: Habermann, Jan
(86) Internationale Anmeldenummer: PCT/EP1999/008821
(87) Internationale Veröffentlichungsnummer: WO 2000/031422

(56) Entgegenhaltungen:
- EP-A- 0 040 186
- DE-A- 19 746 585
- US-A- 5 519 635

## Beschreibung

Die Erfindung betrifft einen Anschlußträger für plattenförmige Mikrokomponenten.

Plattenförmige Mikrokomponenten, wie Mikromischer, Mikropumpen, Mikroventile od. dgl., dienen zur Durchführung von chemischen Reaktionen mit geringsten Massenströmen. Der Einsatz von Mikrokomponenten ermöglicht eine exakte Temperaturkontrolle und gute Durchmischung, so daß eine wesentlich genauere Prozeßkontrolle bei erhöhter Sicherheit ermöglicht wird.

Üblicherweise bestehen die Mikrokomponenten aus mehreren aufeinanderliegenden planparallelen Platten, die in ihren aufeinanderliegenden Oberflächen die für die erforderliche Funktion benötigten Strukturen enthalten. Wegen der guten thermischen Leitfähigkeit und der Strukturierbarkeit bestehen diese Platten üblicherweise aus Silizium (sog. Siliziumwafer), die im Inneren eine der Funktion der Mikrokomponente angepaßten Geometrie enthalten. Daneben ist aber auch der Einsatz anderer, chemisch beständiger und den Einsatzbedingungen angepaßter Werkstoffe möglich.

Bisher wurden in erster Linie einzelne Mikrokomponenten, üblicherweise in plattenförmiger Ausführung, eingesetzt und jeweils einzeln mit den Zufuhr- und Abfuhrleitungen für flüssige und gasförmige Stoffkomponenten sowie - soweit erforderlich - mit elektrischen Anschlüssen versehen. Ein wesentlicher Aspekt des Einsatzes solcher Mikrokomponenten ist jedoch der Anschluß an laborübliche Geräte, damit die Vorteile der Mikrosysteme in labortechnischen Maßstäben eingesetzt werden können.

Aufgabe der Erfindung ist es daher, eine Schnittstelle zwischen Mikrotechnik und Labortechnik zu schaffen, über die die Mikrosysteme in sicherer und einfacher Weise an laborübliche Geräte adaptiert werden können.

Diese Aufgabe wird erfindungsgemäß gelöst durch einen Anschlußträger für plattenförmige Mikrokomponenten zur Durchführung von chemischen Reaktionen mit mindestens einer auf einer Trägerplatte befestigten Trägerschiene, die einen Einsteckschlitz zur Aufnahme eines Einsteckrandes einer plattenförmigen Mikrokomponente aufweist, wobei in mindestens einer der beiden Seitenwände des Einsteckschlitzes der Trägerschiene Leitungsanschlüsse zur Leitung flüssiger und gasförmiger Stoffkomponenten vorgesehen sind, die mit zugeordneten Anschlüssen in mindestens einer Außenseite der plattenförmigen Mikrokomponente verbindbar sind.

Mit diesem Anschlußträger wird neben einem Anschlußsystem gleichzeitig auch eine mechanisch stabile Halterung geschaffen. Das Anschlußsystem ermöglicht die Versorgung mit Reagenzien und die Realisierung eines elektrischen Anschlusses, beispielsweise für die Meßtechnik, Heizung, Kühlung usw. Die Mikrokomponenten können in einfacher Weise angeschlossen und leicht ausgewechselt werden. Durch die Verwendung mehrerer Trägerschienen auf einer gemeinsamen Trägerplatten lässt sich eine räumlich kompakte Unterbringung mehrerer plattenförmiger Mikrokomponenten erreichen. Mit einer solchen universellen Anschlußtechnik wird auf engstem Raum ein mechanisch stabiler Aufbau von Mikrosystemen mit standardisierter Versorgungstechnik möglich.

Gemäß einer bevorzugten Ausführungsform der Erfindung ist vorgesehen, daß mindestens eine der Seitenwände des Einsteckschlitzes mindestens eine Gewindebohrung zur Aufnahme einer Anschlußverschraubung aufweist, die gegen die zugeordnete Außenseite der plattenförmigen Mikrokomponente schraubbar ist. Damit wird gleichzeitig ein dichter Anschluß der Mikrokomponente an die Anschlußverschraubung und zugleich eine sichere Festlegung der plattenförmigen Mikrokomponente in der Trägerschiene erreicht.

Um eine exakte und zuverlässige Ausrichtung der plattenförmigen Mikrokomponente in der Trägerschiene zu gewährleisten, ist in weiterer Ausgestaltung des Erfindungsgedankens vorgesehen, daß an einem Ende des Einsteckschlitzes eine in Schlitzlängsrichtung wirkende Feder angeordnet ist, durch die die plattenförmige Mikrokomponente gegen einen Zentrieranschlag am anderen Ende des Einsteckschlitzes drückbar ist.

Zwischen den Gewindebohrungen oder in der gegenüberliegenden Seitenwand des Einsteckschlitzes können elektrische Kontaktflächen angeordnet sein, die mit zugeordneten elektrischen Kontakten der plattenförmigen Mikrokomponente in Berührung bringbar sind. Damit wird zugleich ein elektrischer Anschluß hergestellt, wie er in vielen Fällen für Meßfühler in der Mikrokomponente, für Heizung, Kühlung oder ähnliche Zwecke erforderlich ist.

In weiterer Ausbildung des Erfindungsgedankens kann vorgesehen werden, daß die Trägerschiene mit einer sich senkrecht zur Trägerplatte erstreckenden Anschlußschiene verbunden ist, die einen Einsteckschlitz zur Aufnahme eines weiteren Einsteckrandes der plattenförmigen Mikrokomponente aufweist, wobei in mindestens einer der beiden Seitenwände des Einsteckschlitzes der Anschlußschiene Leitungsanschlüsse vorgesehen sind, die mit zugeordneten Anschlüssen in mindestens einer Außenseite der plattenförmigen Mikrokomponente verbindbar sind.

Die von der Trägerschiene senkrecht hochstehende Anschlußschiene bietet einerseits die Möglichkeit, dort weitere Leitungsanschlüsse vorzusehen; andererseits bildet diese Anschlußschiene eine stabile Halterung für die eingesteckte plattenförmige Mikrokomponente, so daß auf sonstige Halterungen und Festlegungen verzichtet werden kann.

Weitere vorteilhafte Ausgestaltungen des Erfindungsgedankens sind Gegenstand weiterer Unteransprüche.

Nachfolgend werden Ausführungsbeispiele der Erfindung näher erläutert, die in der Zeichnung dargestellt sind. Es zeigt, jeweils in räumlicher Darstellungsweise:
Fig. 1 einen Anschlußträger für plattenförmige Mikrokomponenten mit einer auf einer Trägerplatte befestigten Trägerschiene,
Fig. 2 einen Anschlußträger mit zusätzlicher Anschlußschiene und
Fig. 3 einen Anschlußträger mit einem von der Trägerschiene getrennten Anschlußhalter.

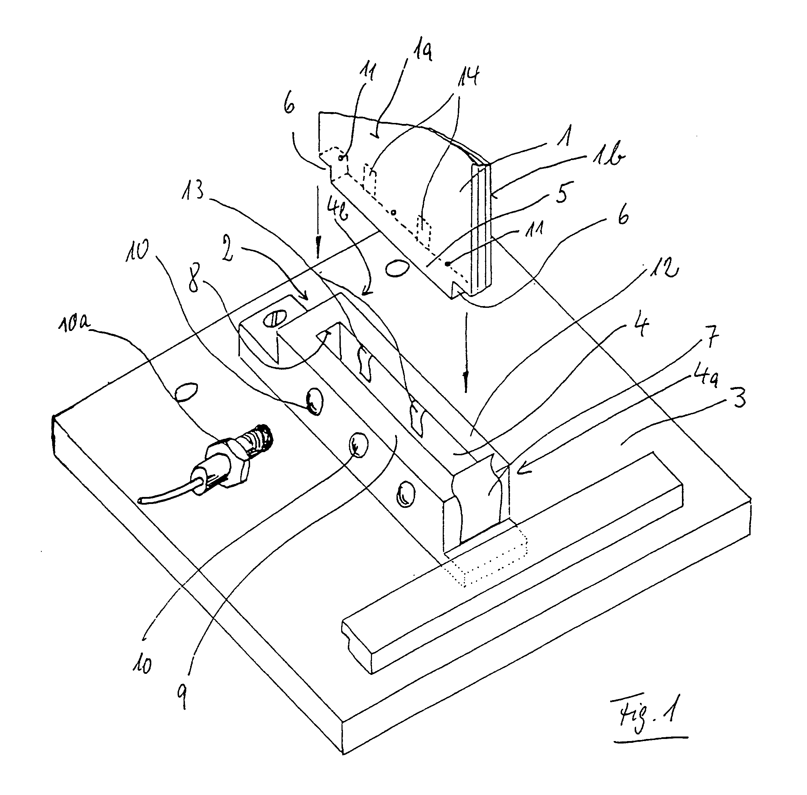

Der in Fig. 1 dargestellte Anschlußträger dient zur Aufnahme einer plattenförmigen Mikrokomponente 1. Eine beispielsweise aus Kunststoff bestehende Trägerschiene 2 ist auf einer Trägerplatte 3 befestigt. Die Trägerschiene 2 weist einen längsverlaufenden Einsteckschlitz 4 auf, in den die plattenförmige Mikrokomponente 1 mit einer Sockelleiste 5 einsteckbar ist. Die Sockelleiste 5 ist von seitlichen Ausnehmungen 6 begrenzt, die an den Enden des Einsteckschlitzes 4 zur Anlage kommen und damit eine exakte Festlegung der Einstecktiefe gewährleisten.

An dem einen Ende 4a des Einsteckschlitzes 4 ist eine in Schlitzlängsrichtung wirkende Feder 7, beispielsweise eine Blattfeder, angeordnet, die den Sockel 5 der plattenförmigen Mikrokomponente 1 gegen einen Zentrieranschlag 8 am anderen Ende 4b des Einsteckschlitzes 4 drückt.

In der einen Seitenwand 9 des Einsteckschlitzes 4 sind mehrere Gewindebohrungen 10 vorgesehen, die sich quer zur Ebene der plattenförmigen Mikrokomponente 1 erstrecken und zur Aufnahme jeweils einer Anschlußverschraubung 10a vorgesehen sind, durch die flüssige oder gasförmige Stoffe der Mikrokomponente 1 zugeführt oder von dieser abgeführt werden. Nach dem Einstecken der Mikrokomponente 1 in den Einsteckschlitz 4 werden die Anschlußverschraubungen gegen die Mikrokomponente 1 verschraubt und dadurch dicht an Anschlüsse 11 in der Außenseite 1a der plattenförmigen Mikrokomponente gedrückt.

In der der Seitenwand 9 gegenüberliegenden Seitenwand 12 des Einsteckschlitzes 4 sind elektrische Kontaktflächen 13, beispielsweise Kontaktfedern, angeordnet, die nach dem Einstecken der Mikrokomponente 1 mit zugeordneten elektrischen Kontakten 14 auf der zugekehrten Außenfläche 1b in Berührung kommen und zum elektrischen Anschluß dienen.

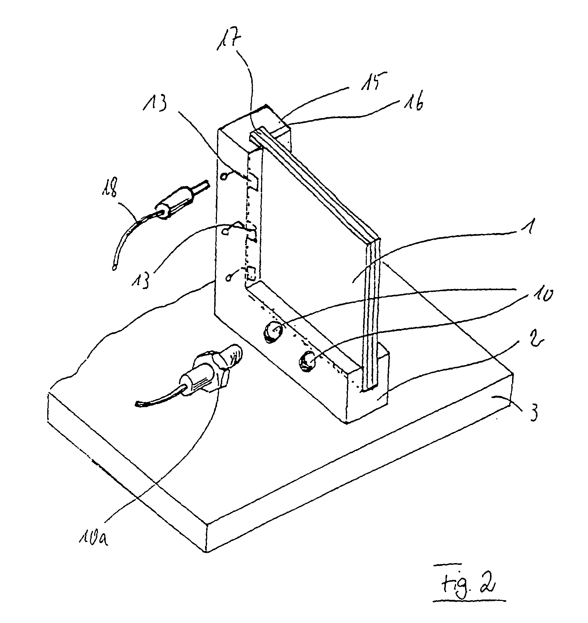

Das Ausführungsbeispiel nach Fig. 2 unterscheidet sich nach dem Ausführungsbeispiel nach Fig. 1 im wesentlichen dadurch, daß die Trägerschiene 2 mit einer Anschlußschiene 15 verbunden ist, die sich senkrecht zur Trägerplatte 3 erstreckt und ebenfalls einen Einsteckschlitz 16 zur Aufnahme eines weiteren Einsteckrandes 17 der plattenförmigen Mikrokomponente 1 aufweist.

Bei dem Ausführungsbeispiel nach Fig. 2 sind in der mit der Trägerplatte 3 verbundenen Trägerschiene 2 nur die Gewindebohrungen 10 zur Aufnahme der Anschlußverschraubungen 10a vorgesehen. Die beschriebenen elektrischen Kontaktflächen 13 sind nur in der Anschlußschiene 15 angeordnet und dienen zum Anschluß elektrischer Leitungen 18.

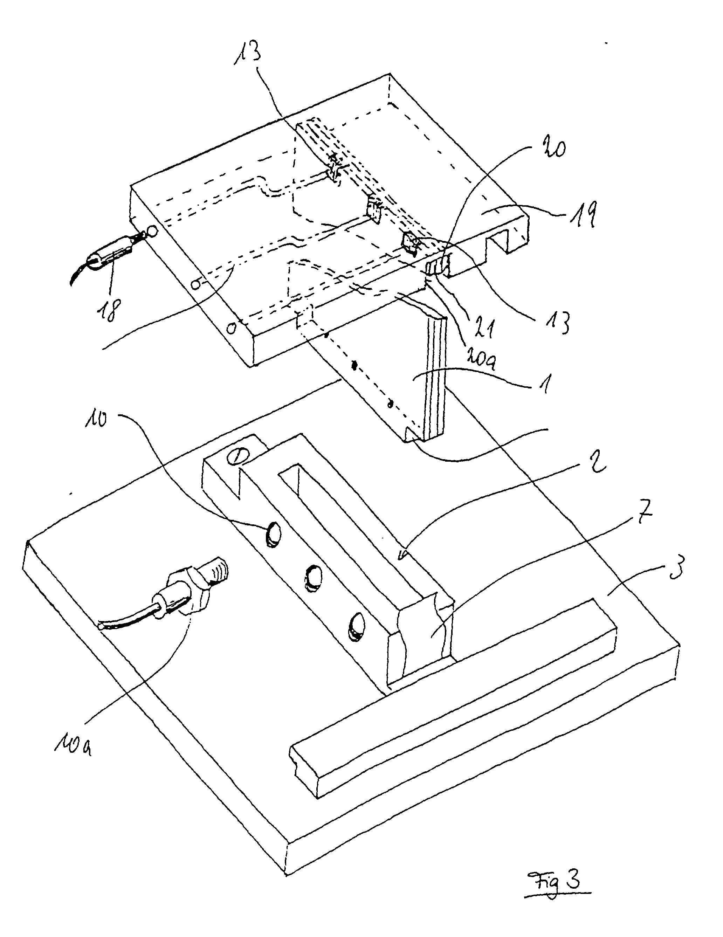

Das Ausführungsbeispiel nach Fig. 3 unterscheidet sich von den vorher beschriebenen Ausführungsbeispielen im wesentlichen dadurch, daß ein von der Trägerschiene 2, die auch hier nur die Gewindebohrungen 10 aufweist, getrennter Anschlußhalter 19 einen Aufnahmeschlitz 20 für einen Rand 21 der plattenförmigen Mikrokomponente 1 aufweist. in der einen Seitenwand 20a des Aufnahmeschlitzes 20 sind die elektrischen Kontaktflächen 13 angeordnet, die mit den zugeordneten Kontakten 14 der plattenförmigen Mikrokomponente 1 in Berührung stehen.

Der Anschlußhalter 19, der auch in geeigneter Weise mit der Trägerplatte 3 verbunden bzw. an dieser befestigt sein kann, fixiert die aufgenommene Mikrokomponente 1 bzw. mehrere solcher aufgenommenen Mikrokomponenten 1 zusätzlich.

Bei allen gezeigten Ausführungsbeispielen können durch Anordnung mehrerer Trägerschienen 2 auf einer gemeinsamen Trägerplatte 3 mehrere Mikrokomponenten 1 aufgenommen werden. So lassen sich durch Hintereinanderschalten mehrerer Mikrokomponenten 1 mehrstufige oder auch parallele Reaktionen auf kleinstem Raum durchführen.

## Patentansprüche

1. Anschlußträger für plattenförmige Mikrokomponenten zur Durchführung von chemischen Reaktionen mit mindestens einer auf einer Trägerplatte (3) befestigten Trägerschiene (2), die einen Einsteckschlitz (4) zur Aufnahme eines Einsteckrandes (5) einer plattenförmigen Mikrokomponente (1) aufweist, wobei in mindestens einer der beiden Seitenwände (9, 12) des Einsteckschlitzes (4) der Trägerschiene (2) Leitungsanschlüsse (10, 10a, 13) zur Leitung flüssiger und gasförmiger Stoffkomponenten vorgesehen sind, die mit zugeordneten Anschlüssen (11) in mindestens einer Außenseite (1a, 1b) der plattenförmigen Mikrokomponente (1) verbindbar sind.

2. Anschlußträger nach Anspruch 1, **dadurch gekennzeichnet, daß** mindestens eine der Seitenwände (9) des Einsteckschlitzes (4) mindestens eine Gewindebohrung (10) zur Aufnahme einer Anschlußverschraubung (10a) aufweist, die gegen die zugeordnete Außenseite (1a) der plattenförmigen Mikrokomponente (1) schraubbar ist.

3. Anschlußträger nach Anspruch 1, **dadurch gekennzeichnet, daß** an einem Ende (4a) des Einsteckschlitzes (4) eine in Schlitzlängsrichtung wirkende Feder (7) angeordnet ist, durch die die plattenförmige Mikrokomponente (1) gegen einen Zentrieranschlag (8) am anderen Ende (4b) des Einsteckschlitzes (4) drückbar ist.

4. Anschlußträger nach Anspruch 2, **dadurch gekennzeichnet, daß** zwischen den Gewindebohrungen (10) oder in der gegenüberliegenden Seitenwand (12) des Einsteckschlitzes (4) elektrische Kontaktflächen (13) angeordnet sind, die mit zugeordneten elektrischen Kontakten (14) der plattenförmigen Mikrokomponente (1) in Berührung bringbar sind.

5. Anschlußträger nach Anspruch 1, **dadurch gekennzeichnet, daß** die Trägerschiene (2) mit einer sich senkrecht zur Trägerplatte (3) erstreckenden Anschlußschiene (15) verbunden ist, die einen Einsteckschlitz (16) zur Aufnahme eines weiteren Einsteckrandes (17) der plattenförmigen Mikrokomponente (1) aufweist, wobei in mindestens einer der beiden Seitenwände des Einsteckschlitzes (16) der Anschlußschiene (15) Leitungsanschlüsse (13) vorgesehen sind, die mit zugeordneten Anschlüssen in mindestens einer Außenseite der plattenförmigen Mikrokomponente (1) verbindbar sind.

6. Anschlußträger nach Anspruch 5, **dadurch gekennzeichnet, daß** die Trägerschiene (2) die Gewindebohrungen (10) zur Aufnahme der Anschlußverschraubungen (10a) und die Anschlußschiene (15) elektrische Kontaktflächen (13) aufweist.

7. Anschlußträger nach Anspruch 1, **dadurch gekennzeichnet, daß** ein von der Trägerschiene (2) getrennter Anschlußhalter (19) einen Aufnahmeschlitz (20) für einen Rand (21) der plattenförmigen Mikrokomponente (1) aufweist und daß in mindestens einer Seitenwand (20a) des Aufnahmeschlitzes (20) elektrische Kontaktflächen (13) angeordnet sind, die mit zugeordneten Kontakten der plattenförmigen Mikrokomponente in Berührung bringbar sind.

## Claims

1. Interconnection support for plate-like microcomponents, for carrying out chemical reactions, having at least one support rail (2) which is attached to a support plate (3) and which has an insertion slot (4) for the accommodation of an insertion edge (5) of a plate-like microcomponent (1), with line connections (10, 10a, 13) which are for conducting liquid and gaseous components of a substance and can be connected to associated connections (11) in at least one outside (1a, 1b) of the plate-like microcomponent (1) being provided in at least one of the two side walls (9, 12) of the insertion slot (4) of the support rail (2) .

2. Interconnection support according to Claim 1, **characterized in that** at least one of the side walls (9) of the insertion slot (4) has at least one threaded hole (10) for the accommodation of a screw connection (10a), which can be screwed against the associated outside (1a) of the plate-like microcomponent (1).

3. Interconnection support according to Claim 1, **characterized in that**, arranged at one end (4a) of the insertion slot (4) is a spring (7), which acts in the longitudinal direction of the slot and by means of which the plate-like microcomponent (1) can be pressed against a centring stop (8) at the other end (4b) of the insertion slot (4).

4. Interconnection support according to Claim 2, **characterized in that** electrical contact surfaces (13), which can be brought into contact with associated electrical contacts (14) of the plate-like microcomponent (1), are arranged between the threaded holes (10) or in the opposite side wall (12) of the insertion slot (4).

5. Interconnection support according to Claim 1, **characterized in that** the support rail (2) is connected to a connection rail (15) which extends perpendicular to the support plate (3) and has an insertion slot (16) for the accommodation of a further insertion edge (17) of the plate-like microcomponent (1), with line connections (13) which can be connected to associated connections in at least one outside of the plate-like microcomponent (1) being provided in at least one of the two side walls of the insertion slot (16) of the connection rail (15).

6. Interconnection support according to Claim 5, **characterized in that** the support rail (2) has the threaded holes (10) for the accommodation of the screw connections (10a) , and the connection rail (15) has electrical contact surfaces (13).

7. Interconnection support according to Claim 1, **characterized in that** a connection holder (19) which is separate from the support rail (2) has an accommodation slot (20) for an edge (21) of the plate-like microcomponent (1), and **in that** electrical contact surfaces (13), which can be brought into contact with associated contacts of the plate-like microcomponent, are arranged in at least one side wall (20a) of the accommodation slot (20) .

## Revendications

1. Support de raccordement pour microcomposants en forme de plaque pour réaliser des réactions chimiques avec au moins un rail de support (2) fixé sur une plaque de support (3), rail qui comporte une fente d'introduction (4) destinée à accueillir un bord enfichable (5) d'un microcomposant en forme de plaque, des raccords de conduites (10, 10a, 13) pour conduire des composants de substance liquides et gazeux étant prévus dans au moins une des deux parois latérales (9, 12) de la fente d'introduction (4) du rail de support (2), lesquels raccords peuvent être reliés à des raccords associés (11) dans au moins une face externe (la, 1b) du composant en forme de plaque.

2. Support de raccordement selon la revendication 1, **caractérisé en ce qu'**au moins une des parois latérales (9) de la fente d'introduction (4) comporte au moins un perçage fileté (10) pour accueillir un raccord fileté de raccordement (10a) qui peut être vissé contre la face externe associée (1a) du microcomposant en forme de plaque (1) .

3. Support de raccordement selon la revendication 1, **caractérisé en ce qu'**un ressort (7) qui agit dans le sens de la longueur de la fente et grâce auquel le microcomposant en forme de plaque (1) peut être pressé contre une butée de centrage (8) à l'autre extrémité (4b) de la fente d'introduction (4) est agencé à une extrémité (4a) de la fente d'introduction (4).

4. Support de raccordement selon la revendication 2, **caractérisé en ce que** des surfaces de contact électriques (13) qui peuvent être mises en contact avec des contacts électriques associés (14) du microcomposant en forme de plaque (1) sont disposées entre les perçages filetés (10) ou dans la paroi latérale opposée(12)de la fente d'introduction (4).

5. Support de raccordement selon la revendication 1, **caractérisé en ce que** le rail de support (2) est relié à un rail de raccordement (15) qui s'étend verticalement par rapport à la plaque de support (3) et qui comporte une fente d'introduction (16) pour accueillir un autre bord enfichable (17) du microcomposant en forme de plaque (1), des raccords de conduites (13) qui peuvent être reliés à des raccords associés dans au moins une face externe du microcomposant en forme de plate-forme (1) étant prévus dans au moins une des deux parois latérales de la fente d'introduction (16) du rail de raccordement (15) .

6. Support de raccordement selon la revendication 5, **caractérisé en ce que** le rail de support (2) comporte les perçages filetés (10) pour accueillir les raccords filetés de raccordement (10a) et **en ce que** le rail de raccordement (15) comporte des surfaces de contact électriques (13).

7. Support de raccordement selon la revendication 1, **caractérisé en ce qu'**un appui de raccordement (19) séparé du rail de support (2) comporte une fente d'accueil (20) pour un bord (21) du microcomposant en forme de plaque (1) et **en ce que** des surfaces de contact électriques (13) pouvant être mises en contact avec des contacts affectés des microcomposants en forme de plaque sont disposées dans au moins une paroi latérale de la fente d'accueil (20) .
